Europäisches Patentamt

European Patent Office

Office européen des brevets

(19)

(11) **EP 1 587 217 A1**

(12) **EUROPEAN PATENT APPLICATION**

(43) Date of publication:
**19.10.2005 Bulletin 2005/42**

(51) Int Cl.$^7$: **H03M 13/27**

(21) Application number: **04019055.5**

(22) Date of filing: **11.08.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (72) Inventors:<br>• **Dinoi, Libero**<br>  **10138 Torino (IT)**<br>• **Benedetto, Sergio**<br>  **10129 Torino (IT)** |
| (30) Priority: **15.04.2004 EP 04425273** | (74) Representative: **Quinterno, Giuseppe et al**<br>**Jacobacci & Partners S.p.A.**<br>**Corso Emilia, 8**<br>**10152 Torino (IT)** |
| (71) Applicant: **Istituto superiore Mario Boella per le Tecnologie**<br>**dell'Informazione e delle Telecomunicazioni**<br>**10138 Torino (IT)** | |

(54) **Pruning methods for the generation of S-random interleavers**

(57)    The method allows to obtain, starting from an initial S-random interleaver permutation ($\Pi_0$) stored in memory devices (2) and having a size N a final S-random permutation ($\Pi_n$) having a smaller size K<N by successive pruning operations or steps which, starting from the initial permutation ($\Pi_0$), yield the final permutation ($\Pi_n$) through an iterative process which is performed by means of electronic processing devices (1), and in which in successive steps selected elements are eliminated from the initial permutation ($\Pi_0$).

The pruning method proceeds by alternatingly applying two different kinds of steps: In odd-numbered steps, the elements of the permuted sequence with the highest values are discarded, and in even-numbered steps, the last elements of the sequence are discarded. The algorithm further employs two moving thresholds, one in the permuted sequence ($\Pi_0$) and one in the inversely permuted sequence ($\Pi_0^{-1}$). If an element with a value smaller than the latter threshold is discarded in an even step, the corresponding element of a size-N reference vector is set.

Fig. 2

Discarded in the even steps
and with values higher than L2

Discarded in the odd
steps but after L1

Discarded in the even steps
and with values lower than L2

Discarded in the odd
steps but before L1

$\Pi$

L1

L2

$\Pi$-1

Flag vector $V_f$

## Description

The present invention relates generally to coding systems for digital communications, and particularly to pruning methods for the obtention of S-random interleavers with a reduced size starting from an initial S-random interleaver having a larger size.

In the present description, following an already established practice in this field, by "interleaver" it is meant the "interleaver permutation" or "interleaver law" associated with an interleaver device in the proper sense of the word.

In particular the invention relates to a pruning method of the kind defined in the introductory portion of claim 1.

Interleavers play a crucial role in systems using turbo-codes.

Interleavers of the S-random type represent, as it is well-known, an optimum class of interleavers, and differently from many other permutation systems, are sufficiently robust with respect to the specific convolutional codes employed and to the puncturing rate applied to the overall code.

Many application systems require a great flexibility in terms of block length and code-rate, and the change of these parameters involves a corresponding modification of the interleaver size. In such cases, it is highly recommendable to obtain, by use of an algorithm, all the needed interleavers from a mother interleaver which exhibits the largest size, avoiding the need to store all the necessary permutation laws.

Unfortunately the known pruning techniques disclosed in the literature generally destroy the properties of S-random interleavers.

A pruning method of the kind defined in the introductory portion of claim 1 is disclosed in EP 1 257 064 A and in M. Ferrari, F. Scalise, S. Bellini, "Prunable S-random Interleavers", in Proc. IEEE Conf. Communications, Vol. 3, 2002, pages 1711-1715.

The pruning method disclosed in said documents provides for discarding all the elements of an initial interleaver which have a value greater than the size of the desired smaller interleaver. That technique allows to store one single interleaver and for the larger interleavers it affords (only) the same spread properties of the smaller interleaver.

It is an object of the present invention to propose a pruning method of the initially specified kind, which allows to overcome the limitations of the above-outlined prior art, permitting to obtain in general S-random interleavers with improved spread properties.

This object is achieved according to the invention by the pruning method the main features of which are defined in claim 1.

It can be shown, in an intuitive manner, and by means of simulations and tests, that the pruning method according to the present invention reduces in a quite less dramatic way the spread properties of the shorter interleavers, the pruning method being suitable for employment with a by far wider range of block sizes or lengths, differently from what was possible with the conventional pruning techniques.

In the following, different variants of the basic pruning methods will be also disclosed, each variant corresponding to a different trade-off between complexity, latency and memory requirements.

The invention also relates to interleaver devices which carry out the above-outlined pruning methods.

Further characteristics and advantages of the invention will become apparent from the detail description which follows, provided merely as a non-limiting example, with reference to the enclosed drawings in which:

   figure 1 is a block diagram of an apparatus which can be used for carrying out a pruning method according to the present invention;
   figure 2 is diagrammatic graphic representation of a start interleaver permutation and the corresponding inverse permutation as well as an associated reference (flag) vector generated in performing a pruning method according to the present invention; and
   figures 3 and 4 show diagrams comparing the performances of interleavers obtained through the method or process according to the invention, with interleavers according to the prior art.

The pruning methods according to the invention provide better results with respect to conventional techniques, for every S-random type interleaver. However, these methods provide optimal results if applied to S-random interleavers obtained with a progressive technique of permutation generation invented by the same inventors of this application, which will be now presented herebelow.

In European patent application EP 1 257 064 A there was proposed an algorithm for the generation of S-random interleavers or, better stated, interleaver permutations, which, starting from a good S-random interleaver permutation of size K and spread S, creates, by extension, a larger or longer interleaver permutation, say of size N, with the same spread properties of the starting interleaver permutation. Although this may be sufficiently acceptable for a small range of interleaver sizes, this constraint may lead to poor results if one has to construct interleavers in a wide range of sizes, as this leads to poor spreading properties of the larger interleavers.

The incremental technique which will be now presented overcomes this limitation. While the algorithm according to the prior art in fact extracts at random an integer representing the position of the new element which is added to the interleaver, the technique which will be now described picks a number from a subset of positions that allows to improve the spread properties.

If we start from a K-sized interleaver with a spread S, the next step in the extension process is to add new positions until we reach a spread S+1. Thus we analyze the permutation and see which pairs of positions [i;j] and [$\Pi$(i);$\Pi$(j)] correspond to the violations that do not permit to reach a spread equal to S+1.

One easy way to overcome these violations is to choose an element with $\Pi$(K+1) = $\psi$, $\psi \in$ [min($\Pi$(i), $\Pi$(j)) + 1; max($\Pi$(i), $\Pi$(j))], and then update all previous K elements or positions of the interleaver by incrementing of one all those greater than or equal to $\psi$.

To eliminate or break, at each step, the maximum number of violations, an interval vector A is created, which contains all position pairs causing violations of the spread properties. Each pair defines an interval, whose internal numbers are suitable for extraction; then we can use the vector A to build a second vector, defined as the position vector B, which is proportional to the attitude of each position to break spread violations.

The vector B is then sorted in descending order and the first element that does not introduce new spread violations is extracted.

This technique permits to improve the spread properties in a very fast way, and to construct interleavers with large sizes having very good spreading properties with a computational complexity that may be competitive even with the direct S-random interleaver generation.

The improved method for the construction of interleavers described above can be performed essentially by the algorithm disclosed herebelow in a pseudo-code formalism:

starting from an interleaver permutation $\Pi$ having a size or length K and a spread $S_{in}$:

- Set dim = K and S=$S_{in}$
- LOOP UNTIL dim = N

  - if dim is even

    * build the interval vector A with the (S+1) spread violations; the intervals are [min($\Pi$(i), $\Pi$(j)) + 1; max ($\Pi$(i), $\Pi$(j))]
    * build the position vector B
    * pick $\psi$ from B, such that it does not introduce new spread violations
    * set $\Pi$(dim+1) =$\psi$
    * $\forall$k$\leq$dim, if $\Pi$(k) $\geq$ $\psi$, set $\Pi$(k)= $\Pi$(k)+1
    * obtain the inverse interleaver $\Pi^{-1}$

  - if dim is odd

    * build the interval vector A with the (S+1) spread violations; the intervals are [min(i,j)+ 1; max(i,j)]

    * build the position vector B
    * pick $\psi$ from B, such that it does not introduce new spread violations
    * set $\Pi^{-1}$(dim+1) =$\psi$
    * $\forall$k $\leq$ dim, if $\Pi^{-1}$(k) $\geq$ $\psi$, set $\Pi^{-1}$(k) = $\Pi^{-1}$(k)+1
    * obtain the interleaver $\Pi$

  - set dim = dim+1
  - if there are no more (S+1) spread violations set S=S+1

- END OF LOOP

The algorithm above allows to yield a wide range of interleavers with different sizes with good spreading properties.

When the system at hand needs to obtain one of them "on the fly", an easily implementable pruning algorithm is required.

For instance, this means that new elements have to be inserted into the interleaver permutation in a way that allows to know their position and discard them very easily.

According to the prior method disclosed in EP 1 257 064 A, this can be obtained for instance starting from a created N-sized interleaver and removing its last N-K positions. This, in turn, requires to use the elements of the position vector B to choose the elements $\Pi(K+i)$, i = 1,..., N-K. That is in fact the pruning rule suggested in EP 1 257 064 A, and it complies very well with the therein aimed criterion of preserving for the extended interleavers the same spread properties of the shortest interleaver. On the contrary, it has serious drawbacks in other cases and in particular when applied to interleavers having an interleaver permutation or an interleaver law obtained by means of the innovative technique described above or the algorithm presented above.

As it will be readily apparent form the following, the pruning method according to the present invention allows to obtain, starting from an initial S-random interleaver permutation stored in memory means and having a size N, i.e. formed of N elements, a final S-random permutation having a smaller size K<N, i.e. formed of K elements, by means of successive pruning operations or steps which, starting from the initial permutation, yield the final permutation through an iterative process carried out by means of electronic processing means with memory. In successive steps of said iterative process elements selected on the basis of predetermined criteria are discarded from the initial permutation.

In particular, in the method according to the invention the final permutation is generated by utilizing a reference vector having a size equal to that of the initial permutation and thus comprising N elements; said reference vector being generated by said processing means in such a way that at each pruning step if the element discarded from the initial permutation has been eliminated on the basis of a predetermined criterion, one element of said reference vector is generated such that its value and its position in the reference vector are indicative of the value of the elements discarded from the initial permutation.

The method according to the invention can be performed in different variants, which will be described in a more detailed way in the following, to reduce the size of a large initial interleaver, named afterwards $\Pi_0(x)$, that is stored in a read-only memory (ROM), to obtain a shorter one, named $\Pi_n(x)$, that is stored in a reserved random-access memory (RAM) area.

A good number of methods according to the invention are in general composed by three tasks:

* identification of the elements to be pruned,
* re-normalization, namely re-definition (scaling) of the value of part of the valid or surviving elements, and
* re-compacting of the interleaver.

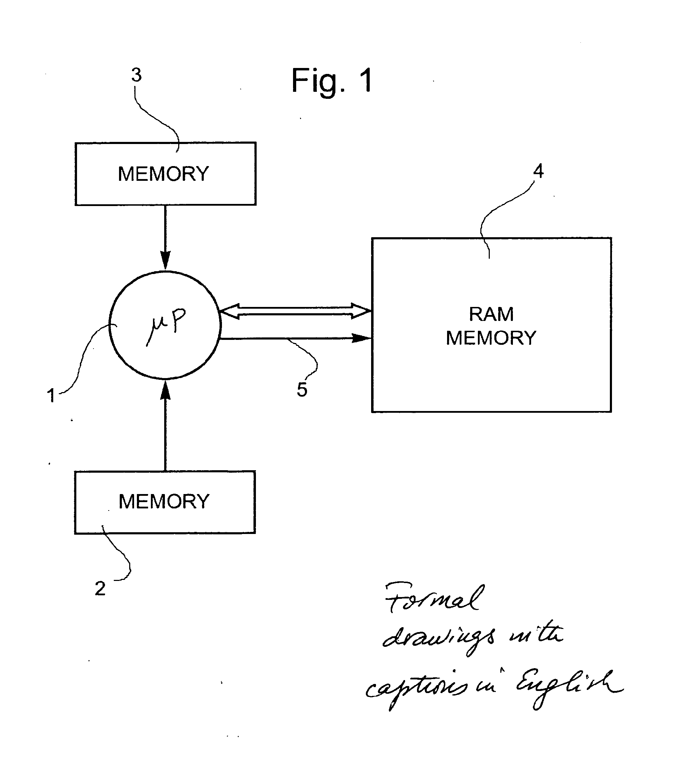

The basic pruning method according to the invention as defined above can be carried out for instance by means of the apparatus shown in figure 1, which comprises a microprocessor 1 with associated memory devices 2 and 3. The memory devices indicated 2 are of the read-only (ROM) kind and serve to store the N-sized initial or start interleaver $\Pi_0$ and, possibly, its inverse $\Pi_0^{-1}$, whereas the memory devices 3 can be either of the read-only (ROM) type or of the random-access (RAM) type and serve to store the reference or auxiliary vector(s), described in the following, and the final interleaver $\Pi_n$.

The microprocessor 1 is coupled to random-access memory (RAM) devices 4 through an address line 5. Said memory devices are used for implementing the algorithm for decoding the turbo-codes. Said algorithm is based on the iterative performance of a variant of the so-called BCJR algorithm by so-called SISO (Soft Input Soft Output) units: in the case of only two constituent convolutional codes, each iteration is composed of two half-iterations, in the first one of which the data are written and read in natural order from memory 4, and in the second one of which data are written and read in the order determined by the interleaver permutation or interleaver law.

In the pruning methods according to the invention, in those steps which we conventionally define as "odd" steps, i.e. the steps at which a pruning operation is made onto a permutation having an odd size, the elements of the interleaver which have the highest values are discarded, whereas in those steps which we conventionally define as "even" steps, i.e. the steps in which a pruning operation is made onto an interleaver permutation having an even size, the elements having the highest position indices, namely the last elements of the permutation, are eliminated.

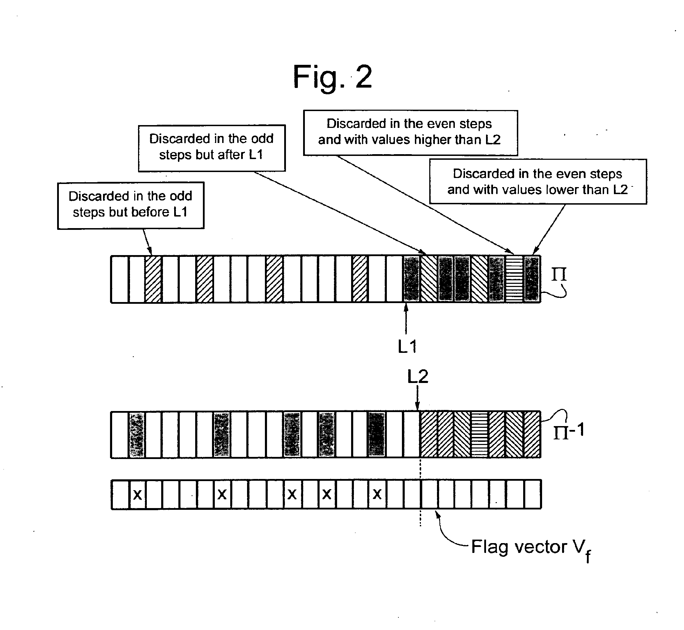

For a better understanding of the following remarks reference can be made to figure 2 which gives a graphic representation of an initial interleaver permutation, indicated $\Pi$, formed of 25 elements, and, therebelow, a representation of the corresponding inverse permutation $\Pi^{-1}$.

At the end of the pruning process of the invention, as shown in Figure 2, all the values discarded in the even steps and some of those deleted in the odd steps will form an end or tail group of consecutive deleted elements, while the other eliminated values will be scattered on the rest of the permutation. The pruned elements are distributed in a similar pattern also in the inverse interleaver $\Pi^{-1}$.

The thresholds which separate the end or tail groups of consecutive discarded elements in the permutation $\Pi$ and in the inverse permutation $\Pi^{-1}$, respectively, are denoted as L1 and L2.

In various pruning methods according to the invention the main source of complexity lies in the re-normalization and re-compacting operations performed in the innermost loops. It is possible to decrease the number of required operations avoiding to perform the above-mentioned operations for each deleted element.

This can be done by keeping track of the deleted elements updating the thresholds L1 and L2, and building a reference or flag vector $V_f$, which has been graphically represented by way of example in figure 2.

The flag vector $V_f$ has a size N and comprises N binary elements or flags assuming each a predetermined value or state (set to "1", for instance) when their position corresponds to the value of an element discarded from the initial permutation $\Pi$ as being placed at the last position of a permutation of odd size. Such 'set' elements or flags of vector $V_f$ have been indicated "x" in the representation of Figure 2.

The values of the thresholds L1 and L2, and the flag vector $V_f$, obtained in a first phase of the pruning method, can be conveniently used in a second and a third phase for performing the re-normalisation of surviving or remaining elements of the permutation. This allows to lower significantly the overall computational complexity.

In the following some techniques will be described, which rely on these principles, but differing in the way they exploit the flag vector $V_f$. A preliminary remark is necessary to analyze the average complexity of said techniques: when pruning an N-sized interleaver to obtain a K-sized one, the threshold L1 and L2 can be approximated as:

$$L1 = L2 = \sqrt{K N} \tag{1}$$

Algorithm A

A first embodiment of the general method of the invention, that we will call now onward "Algorithm A", is composed essentially of three main cycles.

In the first cycle, the flag vector $V_f$ is computed and the thresholds L1 and L2 are updated:

- Set dim = N-1, L1=L2=N

- LOOP UNTIL dim<K

- if dim is even:

  - Set L1=L1-1
  - LOOP UNTIL $\Pi_0(L1)<L2$
  - Set L1=L1-1
  - END OF LOOP
  - Set $V_f(\Pi_0(LI)) =1$

- if dim is odd:

  - Set L2=L2-1
  - LOOP UNTIL $V_f(L2)=0$
  - Set L2=L2-1
  - END OF LOOP

- Set dim = dim-1

- END OF LOOP

In the second cycle, after the permutation $\Pi_0$ is copied to $\Pi_n$, the positions of the latter vector are re-normalized with the help of the de-interleaver $\Pi_0^{-1}$ and of the flag vector $V_f$.

- Copy the first L1 positions of $\Pi_0$ to $\Pi_n$
- Set the number of positions to be discarded DP=L2-K and i=L2-1
- LOOP UNTIL DP=0
- if $V_f(i) < L2$ set DP=DP-1 or else decrease $\Pi_n(\Pi_0^{-1}(i))$ of DP
- Set i=i-1
- END OF LOOP

Scanning the interleaver as described here is equal to scan it starting from the elements with the highest values and ending with the elements with the lower values.

Finally, in the third cycle, the permutation $\Pi_n$ is re-compacted by eliminating all the elements whose value exceeds K, or, equivalently, L2:

- Set cnt=0 and i=0
- LOOP UNTIL i=L1
- if $\Pi_n(i) < L2$ set $\Pi_n(cnt) = \Pi_n(i)$ and cnt=cnt+1
- Set i=i+ 1
- END OF LOOP

The complexity of the algorithm A can as a whole be approximated as:

$$C = 3N + 3K + 2\sqrt{K\,N} \tag{2}$$

Algorithm B

A variant of the basic method of the invention, defined "Algorithm B" in the following, applies the same principles of the previous one (Algorithm A), but gets rid of the de-interleaver. The re-normalization step is performed with relatively low complexity, exploiting the computations already performed for the closest previous elements.

In fact, the re-normalization is performed decreasing the value of the i-th element of $\Pi_0$ by a number equal to the number of "set" flags contained in $V_f$ before the index $\Pi_0(i)$. In this case for every of the K elements of the pruned interleaver, one should scan the flag vector $V_f$ for $\Pi_0$ (i) positions.

Alternatively, if D is an integer greater than zero and lesser than N, we can find amongst the D previously updated elements the one, with index $i_D$, such that $\Pi_0(i_D)$ is closest to $\Pi_0(i)$. Then the flag vector is to be scanned only for a number of positions equal to the difference between $\Pi_0(i_D)$ and $\Pi_0(i)$, and decrease the current element of the number of flags in the said interval and of the difference between $\Pi_0(i_D)$ and $\Pi_n(i_D)$.

Therefore, firstly one has to obtain the thresholds L1 and L2 and the flag vector $V_f$, as in the first cycle of the Algorithm A, and then the first L1 elements of $\Pi_0$, as in the second cycle of the Algorithm A. Then $\Pi_n$ is re-normalized:

- Set i=0
- LOOP UNTIL i=L1
- if $\Pi_n(i) < L2$ find in the D previous elements the $i_D$-th element such that $\Pi_0(j) < L2$ and that the difference $\Delta = \Pi_0(i_D) - \Pi_0(i)$ is minimum.
- Set $N_f = 0$
- if $\Delta > 0$

  - if $\Delta > \Pi_0(i)$, count $N_f$, i.e the number of flags in $V_f$ in the interval $[0; \Pi_0(i)]$ and set $\Pi_n(i) = \Pi_n(i) - N_f$
  - if $\Delta \leq \Pi_0(i)$, count $N_f$, the number of flags in $V_f$ in the interval $[\Pi_0(i); \Pi_0(i) + \Delta]$ and set $\Pi_n(i) = \Pi_n(i) + N_f + \Pi_n(i_D) - \Pi_0(i_D)$

- if $\Delta < 0$

  - if $-\Delta > L2 - \Pi_0(i)$, count $N_f$, i.e. the number of flags in $V_f$ in the interval $[\Pi_0(i); L2]$ and set $\Pi_n(i) = \Pi_n(i) + N_f + K - L2$
  - if $-\Delta \leq L2 - \Pi_0(i)$, count $N_f$, the number of flags in $V_f$ in the interval $[\Pi_0(i) + \Delta; \Pi_0(i)]$ and set $\Pi_n(i) = \Pi_n(i) - N_f + \Pi_n(i_D) - \Pi_0(i_D)$

- Set i=i+1
- END OF LOOP

Finally, in the third cycle the re-compacting step is performed as already previously described. The overall complexity of this variant of the method can be approximated as:

$$C = \frac{K\,N}{2(1 + D)} + 2KD + 3N + 3K + 2\sqrt{K\,N} \tag{3}$$

Unlike Algorithm A, this variant does not need the de-interleaver $\Pi_0^{-1}$, so a memory of 2N is required.

Algorithm C

This variant of the method according to the invention has a complexity that can be lowered to that of Algorithm A by trading-off a small quantity of additional memory. In the previous variant (Algorithm B) the re-normalization step is performed exploiting the information implicitly present in the updated values of the neighbouring elements. In this variant, defined Algorithm C, we construct a small vector of (NP) elements (with P « 1) named $V_p$: the vector $V_p(i)$ contains the number of flags set in $V_f$ in the interval $[0; i(1+\lfloor L2/(NP)\rfloor)]$, where $\lfloor x \rfloor$ is the integer part of x. Then the flag vector $V_f$ has to be scanned, for each of the K elements of the pruned interleaver, in the worst case for L2/NP elements.

Then, as in the preceding two algorithms, we have to obtain the thresholds L1 and L2 and the flag vector $V_f$ and to copy to $\Pi_n$ the first L1 elements of $\Pi_0$.

Thereafter in the second cycle we construct the vector $V_p$:

- Set i=0 and $N_f$=0
- LOOP UNTIL i=L2
- if $V_f(i)$ =1 set $N_f=N_f+1$
- if $(1 +\lfloor L2/(NP)\rfloor)$ divides i, set $V_p(i/(1+\lfloor L2/(NP)\rfloor)) = N_f$
- Set i=i+1
- END OF LOOP

In the successive cycle, the vectors $V_p$ and $V_f$ are exploited to perform the re-normalization step:

- Set i=0
- LOOP UNTIL i=L1
- Set $N_f$=0
- If $\Pi_n(i)$ <L2

  - Compute K = $\Pi_n(i)(1+\lfloor L2/(NP)\rfloor)$ and round it to the nearest integer m
  - if m = NP, set m = m -1
  - if K ≥ m, compute the number of flags $N_f$ in $V_f$ in the interval $(m(1+\lfloor L2/(NP)\rfloor); \Pi_0(i))$ and set $\Pi_n(i)=\Pi_n(i)-N_f-V_p(m)$
  - if K ≤ m, compute the number of flags $N_f$ in $V_f$ in the interval $(\Pi_0(i); m(1+\lfloor L2/(NP)\rfloor))$ and set $\Pi_n(i)=\Pi_n(i)+N_f-V_p(m)$

- Set i=i+1
- END OF LOOP

In the last loop the usual recompaction steps are carried out.

The overall average complexity of the algorithm C is

$$C = \frac{K\sqrt{KN}}{2NP} + 3N + 3K + 3\sqrt{KN} + NP \qquad (4)$$

The total memory required by this algorithm amounts to (2+P)N; it is easy to deduce from the above expression of the complexity that if P is increased, i.e. if the memory requirements grow, the complexity becomes lower.

Algorithm D

If extra cycles, i.e. operations of reading non-valid elements of the initial permutation, are tolerated, the traditional pruning method according to EP 1 257 064 A requires no beforehand computations but only to compare every element of the original interleaver with the new interleaver size. While in the first semi-iteration the SISO module reads and writes data following the natural order of the addresses from the first K positions of the memory device, in the second half-iteration the data are read and written from the said memory device in the order determined by the interleaver and in that phase every element of the initial permutation greater than K is ignored. Clearly, no RAM is required. Since the elements to be discarded are scattered on the whole length of the interleaver, in the worst case all the interleaver has to be scanned in order to perform interleaving.

In a first variant of the method according to Algorithm C, denoted as Algorithm D, only the steps necessary to obtain L1,L2 and the vector $V_f$ are performed, and, while computing $V_f$, also the positions discarded in the odd steps are considered. Thus the elements of the flag vector $V_f$ take a predetermined value (for instance set to "1") when their position corresponds to the value of an element discarded from the initial permutation. In the first semi-iteration the SISO module reads and writes data following the natural order of the addresses avoiding the i-th position if $V_f(i)$ is "flagged". Similarly, in the second semi-iteration the data are read and written in the order of the initial permutation, avoiding the $\Pi_0(i)$ -th address if the corresponding element $V_f(\Pi_0(i))$ is "flagged".

It is not necessary to scan the interleaver in its entire length, because, as previously explained, the last elements are discarded, so the number of extra-cycles is somewhat reduced, with respect to the previous case.

Algorithm E

A further variant of the method defined above as Algorithm C, here denoted as Algorithm E, avoids the computations each time necessary to obtain the flag vector $V_f$, using a vector of N integers, named $V_{aux}$, stored in a ROM and containing the same information of $V_f$. For each flag set to 1, we store the step, i.e. the interleaver size or length, during which that position was flagged, so that, when writing/reading in natural (scrambled) order, the i-th address is discarded if $V_{aux}(i)$ is greater than K, and, similarly, when writing/reading in scrambled order, the $\Pi_0(i)$ -th address is discarded if $V_{aux}(\Pi_0(i))$ is greater than K.

We can now summarize the characteristics of the different pruning techniques that we have described so far. Their complexity and their memory requirements are summarised in the following Table.

| PRUNING METHOD | COMPLEXITY | ROM Integers | RAM Integers | RAM Bits | Extra-cycles |
|---|---|---|---|---|---|
| EP 1 257 064 A | $N+K$ | N | N | 0 | 0 |
| Algorithm A | $3N+3K+2\sqrt{K\,N}$ | 2N | N | N | 0 |
| Algorithm B | $3N+3K+2\sqrt{K\,N+2kD+\dfrac{kN}{2(1+D)}}$ | N | N | N | 0 |
| Algorithm C | $3N+3K+3\sqrt{K\,N}+NP+\dfrac{K\sqrt{K\,N}}{2NP}$ | N | $(1+P)N$ | N | 0 |
| EP 1 257 064 A | 0 | N | 0 | 0 | $N-K$ |
| Algorithm D | $\dfrac{7N}{2}-\dfrac{3K}{2}-2\sqrt{K\,N}$ | N | 0 | N | $\sqrt{K\,N}-K$ |
| Algorithm E | 0 | 2N | 0 | 0 | $\sqrt{K\,N}-K$ |

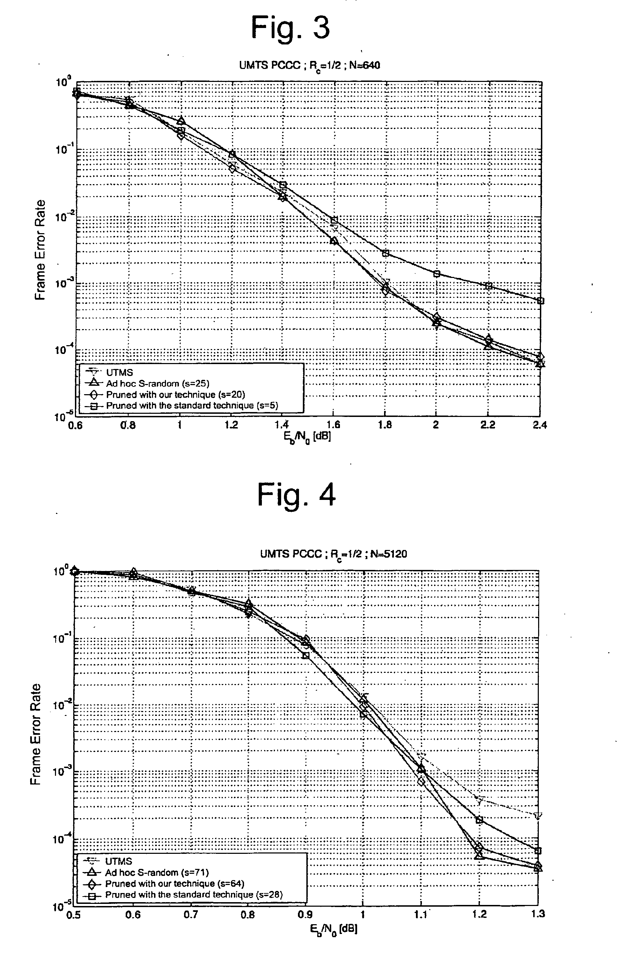

In the diagram shown in figure 3, which illustrates the frame error rate (FER) as a function of $E_b/N_0$, where $E_b$ is the energy per bit and No is the spectral density of the Gaussian white noise, there are compared the characteristics of two S-random interleavers having a length of 640, obtained starting from an S-random interleaver generated by a standard technique with a length of 32768 and a spread S=195, with a standard pruning technique and with the new method, with an interleaver specially designed for that same length, and with the interleaver proposed by the UMTS standard.

Similarly, in figure 4 there are compared the features of two S-random interleavers of length 5120 obtained starting from an S-random interleaver generated by the standard technique, with a length of 32768 and a spread S=195, with the standard pruning technique and the new method, with an interleaver specially designed for that length and with the interleaver proposed by the UMTS standard.

Naturally, the principle of the invention remaining the same, the form of embodiment and the particulars of construction can be widely modified with respect to what has been described and illustrated by way of non-limiting example, without departing from the scope of the invention as defined in the annexed claims.

**Claims**

1. A pruning method for obtaining, starting from an initial S-random interleaver permutation ($\Pi_0$) stored in memory means (2) and having a size (N), i.e. formed of N elements, a final S-random permutation ($\Pi_n$) having a smaller size K<N, i.e. formed of K elements, by means of successive pruning operations or steps which, starting from the initial permutation ($\Pi_0$), yield the final permutation ($\Pi_n$), through an iterative process carried out by means of electronic processing means (1), and in which in successive steps elements selected on the basis of predetermined criteria are discarded from the initial permutation ($\Pi_0$);

   the method being **characterised in that** the final permutation ($\Pi_n$) is generated by utilising a reference vector ($V_f$; $V_{aux}$) having a size (N) equal to that of the initial permutation ($\Pi_0$) and comprising thus N elements; said reference vector ($V_f$; $V_{aux}$) being generated by said processing means (1) in such a way that at each pruning step if the element discarded from the initial permutation ($\Pi_0$) has been eliminated on the basis of a predetermined criterion, one element of said reference vector ($V_f$, $V_{aux}$) is generated such that the value ("0", "1"; $V_{aux}(i)$) thereof and the position thereof in the reference vector ($V_f$; $V_{aux}$) are indicative of the value of the element discarded from the initial permutation ($\Pi_0$).

2. A method according to claim 1, wherein

   - in a first phase an N-sized reference vector ($V_f$) is generated, comprising N binary elements or flags which have each a predetermined value or state ("set") when the position thereof corresponds to the value of an element discarded from the initial permutation as being placed at the last valid position of an initial or intermediate permutation of odd size, and a first and a second threshold position (L1; L2) are computed, which in the initial permutation ($\Pi_0$) and in the corresponding inverse permutation ($\Pi_0^{-1}$), respectively, separate the end tail group of consecutive deleted or discarded values from the remaining portion of the permutation ($\Pi_0$) and the inverse permutation ($\Pi_0^{-1}$), respectively;
   - in a second phase the values of the elements of the initial permutation ($\Pi_0$) are re-normalized using the reference vector ($V_f$) and on the basis of the computed values of said threshold positions (L1; L2), and
   - in a third phase the permutation obtained in said second phase is re-compacted by eliminating all the elements thereof which are greater than K.

3. A method according to claim 2, wherein in said second phase the values of the elements of the initial permutation ($\Pi_0$) are re-normalized also by means of the inverse permutation ($\Pi_0^{-1}$) of the initial permutation.

4. A method according to claim 2, wherein in said second phase the values of the elements of the initial permutation are re-normalised by decreasing the value of the i-th element of the initial permutation by a number equal to the number of flags set contained in the reference vector ($V_f$) before the index $\Pi_0(i)$, where $\Pi_0$ is the original or initial permutation.

5. A method according to claim 2, wherein, having indicated D an integer greater than zero and smaller than N, in said second phase the values of the elements of the initial permutation are re-normalised with the following operations:

   - Set i=0
   - LOOP UNTIL i=L1
   - if $\Pi_n(i)$ < L2 find in the D previous elements of the initial permutation $\Pi_0$ the $i_D$-th element such that $\Pi_0(i_D)$ < L2 and that the difference $\Delta = \Pi_0(i_D) - \Pi_0(i)$ is minimum.
   - Set $N_f$ = 0
   - if $\Delta$>0

       - if $\Delta > \Pi_0(i)$ , count $N_f$, i.e the number of flags in $V_f$ in the interval [0; $\Pi_0(i)$] and set $\Pi_n(i) = \Pi_n(i)-N_f$
       - if $\Delta \leq \Pi_0(i)$, count $N_f$ , i.e. the number of flags in $V_f$ in the interval [$\Pi_0(i)$ ; $\Pi_0(i)+\Delta$] and set $\Pi_n(i) = \Pi_n(i) + N_f + \Pi_n(i_D) - \Pi_0(i_D)$

   - if $\Delta$<0

       - if $-\Delta > L2 - \Pi_0(i)$, count $N_f$, i.e. the number of flags in $V_f$ in the interval [$\Pi_0(i)$; L2] and set $\Pi_n(i) = \Pi_n(i) + N_f + K-L2$
       - if $-\Delta \leq L2 - \Pi_0(i)$, count $N_f$, the number of flags in $V_f$ in the interval [$\Pi_0(i)+\Delta$; $\Pi_0(i)$] and set $\Pi_n(i) = \Pi_n(i) -$

$$N_f + \Pi_n(i_D) - \Pi_0(i_D)$$

- Set i=i+1
- END OF LOOP

6. A method according to claim 2, wherein in said second phase the values of the elements of the initial permutation are re-normalised by means of a further vector having NP (P<<1) integers, containing the number of flags set in the reference vector ($V_f$) in an interval comprised between zero and $i_{\lfloor 1+L2/NP \rfloor}$, where $\lfloor x \rfloor$ is the integer part of x and L2 is the above-mentioned second threshold.

7. A method according to claim 1, wherein in a first phase an N-sized reference vector ($V_f$) is generated, comprising N binary values or flags which assume each a predetermined value or state ("set") when the element having the corresponding position in the initial permutation ($\Pi_0$) is eliminated in the above-said iterative process as being placed in the last position of a permutation having an odd size, or as being the element with the maximum value in a permutation having an even size, and wherein the memory means (4) are read in a first semi-iteration following the natural order of their addresses, eliminating the i-th address if the i-th value of the flag vector ($V_f$) is "set", and in a second semi-iteration are read following the order established by the interleaver, eliminating the $\Pi_0(i)$ -th address when the $\Pi_0(i)$ -th value of the flag vector ($V_f$) is "set".

8. A method according to claim 1, wherein in memory means there is formed and stored a reference or auxiliary vector ($V_{aux}$) of N integers, containing information indicative of:

   * the values, in the initial permutation ($\Pi_0$), of the elements which during the above-mentioned iterative process are discarded as being placed at the last position of a permutation having an odd size, or as being the element having the maximum value in a permutation of even size; and
   * the size of the permutation from which each of said elements has been eliminated, and

   wherein the memory means (4) are successively read in a first semi-iteration following the natural order of their addresses, discarding the i-th address if the i-th value of the auxiliary vector ($V_{aux}$) is greater than K, and in a second semi-iteration are read following the order established by the interleaver, eliminating the $\Pi_0(i)$-th address when the $\Pi_0(i)$-th of the auxiliary vector ($V_{aux}$) is greater than K.

9. An interleaver device, predisposed for carrying out a pruning method according to one or more of the preceding claims.

Fig. 1

Formal
drawings with
captions in English

# Fig. 2

Discarded in the odd
steps but after L1

Discarded in the even steps
and with values higher than L2

Discarded in the even steps
and with values lower than L2

Discarded in the odd
steps but before L1

$\Pi$

L1

L2

$\Pi$-1

Flag vector $V_f$

# Fig. 3

UMTS PCCC ; $R_c=1/2$ ; N=640

Frame Error Rate vs $E_b/N_0$ [dB]

Legend:
- UTMS
- Ad hoc S-random (s=25)
- Pruned with our technique (s=20)
- Pruned with the standard technique (s=5)

# Fig. 4

UMTS PCCC ; $R_c=1/2$ ; N=5120

Frame Error Rate vs $E_b/N_0$ [dB]

Legend:
- UTMS
- Ad hoc S-random (s=71)
- Pruned with our technique (s=64)
- Pruned with the standard technique (s=28)

**European Patent Office**

## EUROPEAN SEARCH REPORT

Application Number

EP 04 01 9055

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 00/10257 A (HUGHES ELECTRONICS CORP) 24 February 2000 (2000-02-24) | 1,9 | H03M13/27 |
| A | * page 13 - page 23 * ----- | 2-8 | |
| A | DINOI L, BENEDETTO S: "Design of Prunable S-Random Interleavers" INT. SYMPOSIUM ON TURBO CODES AND RELATED TOPICS, 30 September 2003 (2003-09-30), pages 279-282, XP001203420 BREST Section 2.5 ----- | 1-9 | |
| D,A | FERRARI M ET AL: "Prunable S-random interleavers" ICC 2002. 2002 IEEE INTERNATIONAL CONFERENCE ON COMMUNICATIONS. CONFERENCE PROCEEDINGS. NEW YORK, NY, APRIL 28 - MAY 2, 2002, IEEE INTERNATIONAL CONFERENCE ON COMMUNICATIONS, NEW YORK, NY : IEEE, US, vol. 1, 28 April 2002 (2002-04-28), pages 1711-1715, XP010589779 ISBN: 0-7803-7400-2 * the whole document * ----- | 1-9 | |
| A | DANESHGARAN F, MULASSANO P: "Interleaver pruning for construction of variable length turbo codes" IEEE TRANSACTIONS ON INFORMATION THEORY, vol. 50, no. 3, 31 March 2004 (2004-03-31), pages 455-467, XP002300502 ISBN: 0-7803-7501-7 * page 456, column 2 - page 458, column 1 * ----- | 1-9 | |

**TECHNICAL FIELDS SEARCHED (Int.Cl.7)**

H03M

The present search report has been drawn up for all claims

| Place of search | Date of completion of the search | Examiner |
|---|---|---|
| Munich | 14 October 2004 | Holzlöhner, R |

EPO FORM 1503 03.82 (P04C01)

**ANNEX TO THE EUROPEAN SEARCH REPORT
ON EUROPEAN PATENT APPLICATION NO.**

EP 04 01 9055

This annex lists the patent family members relating to the patent documents cited in the above-mentioned European search report.
The members are as contained in the European Patent Office EDP file on
The European Patent Office is in no way liable for these particulars which are merely given for the purpose of information.

14-10-2004

| Patent document cited in search report | | Publication date | Patent family member(s) | | Publication date |
|---|---|---|---|---|---|
| WO 0010257 | A | 24-02-2000 | AU | 5675499 A | 06-03-2000 |
| | | | EP | 1046236 A1 | 25-10-2000 |
| | | | JP | 3453122 B2 | 06-10-2003 |
| | | | JP | 2002523915 T | 30-07-2002 |
| | | | US | 2002087923 A1 | 04-07-2002 |
| | | | WO | 0010257 A1 | 24-02-2000 |
| | | | US | 6334197 B1 | 25-12-2001 |

EPO FORM P0459

For more details about this annex : see Official Journal of the European Patent Office, No. 12/82